# EUROPÄISCHE PATENTSCHRIFT

(11) **EP 1 668 715 B1**
(45) Veröffentlichungstag und Bekanntmachung des Hinweises auf die Patenterteilung: **19.11.2008**
(21) Anmeldenummer: 04786880.7
(22) Anmeldetag: 29.09.2004
(51) Int. Cl.: H01L 41/083, H01L 41/187

(54) **PIEZOELEKTRISCHES KERAMIKMATERIAL, VIELSCHICHTBAUELEMENT UND VERFAHREN ZUR HERSTELLUNG DES KERAMIKMATERIALS**
PIEZOELECTRIC CERAMIC MATERIAL, MULTI-LAYERED COMPONENT AND METHOD FOR THE PRODUCTION OF A CERAMIC MATERIAL
MATERIAU CERAMIQUE PIEZOELECTRIQUE, COMPOSANT MULTICOUCHE ET PROCEDE DE FABRICATION DU COMPOSANT CERAMIQUE

(30) Priorität: 30.09.2003 DE 10345499
(43) Veröffentlichungstag der Anmeldung: 14.06.2006
(73) Patentinhaber: EPCOS AG, 81669 München (DE)
(72) Erfinder: FELTZ, Adalbert, A-8530 Deutschlandsberg (AT); FLORIAN, Heinz, A-8524 Bad Gams (AT); OTTLINGER, Marion, A-8530 Deutschlandsberg (AT); RAGOSSNIG, Sigrid, A-9360 Friesach (AT); SEDLMAIER, Peter, A-9113 Ruden (AT)
(74) Vertreter: Epping, Wilhelm
(86) Internationale Anmeldenummer: PCT/DE2004/002168
(87) Internationale Veröffentlichungsnummer: WO 2005/034256

(56) Entgegenhaltungen:
- WO-A-01/45138
- DE-A1- 10 101 188
- BRYKNAR Z ET AL: "ESR and optical spectroscopy of copper-doped PLZT electro-optic ceramics" APPLIED PHYSICS A (MATERIALS SCIENCE PROCESSING) SPRINGER-VERLAG GERMANY, Bd. A66, Nr. 5, Mai 1998 (1998-05), Seiten 555-559, XP002344617 ISSN: 0947-8396

## Beschreibung

Die Erfindung betrifft ein piezoelektrisches Keramikmaterial der allgemeinen Zusammensetzung ABO₃ das im wesentlichen Bleizirkonattitanat enthält und ein Perowskitgitter aufweist, wobei A für A-Plätze und B für B-Plätze des Kristallgitters steht. Die Erfindung betrifft des weiteren ein Verfahren zur Herstellung dieses Keramikmaterials.

Ein solches Keramikmaterial ist insbesondere für Vielschicht-Bauelemente mit einem Stapel aus mehreren Keramikschichten und zwischen Keramikschichten angeordneten Elektrodenschichten geeignet.

Derartige piezokeramische Bauelemente sind zum Beispiel als Aktoren in Piezostapeln (Piezostacks) nutzbar, indem durch Spannungsansteuerung eine trägheitsarme mechanische Auslenkung vergleichsweise hoher Kraft erreicht wird, oder sie gestatten die Erzeugung hoher elektrischer Spannungen beziehungsweise dienen in entsprechenden Vorrichtungen der Detektion mechanischer oder der Erzeugung akustischer Schwingungen.

Bisherige technische Lösungen basieren vorwiegend auf Keramikmassen vom Strukturtyp der Perowskite der allgemeinen Formel ABO₃, wobei die piezoelektrischen Eigenschaften im ferroelektrischen Zustand zum Tragen kommen. Als besonders vorteilhaft haben sich durch bestimmte Zusätze modifizierte Bleizirkonattitanat - Keramiken, Pb(Zr₁₋ₓTiₓ)O₃ = PZT, erwiesen, deren Zusammensetzung auf die sogenannte morphotrope Phasengrenze zweier koexistierender ferroelektrischer Phasen eingestellt ist. Zwischen den nach typischen Verfahren der Keramik insbesondere Folientechnologie hergestellten Keramikschichten befinden sich mittels Siebdruck aufgebrachte Edelmetall - Innenelektroden, zum Beispiel Ag/ Pd im Molverhältnis 70 /30. Bei bis zu mehreren hundert Elektrodenschichten pro Bauelement sind die Bauelemente dadurch mit erheblichen Kosten belastet. Die Edelmetallelektroden ermöglichen es, die im Prozeß der Keramikfolienherstellung angewandten Dispergatoren und Binder sowie die weiteren organischen Additive und ebenso die organischen Bestandteile der Siebdruck - Metallpaste aus den Vielschichtstapeln thermisch an der Luft durch Depolymerisation und Oxidation zu eliminieren, so dass anschließend eine Sinterverdichtung bei ca. 1100 bis 1150°C ermöglicht wird, ohne daß Reduktionseffekte, etwa bedingt durch verbliebene Kohlenstoffreste, wirksam werden, die die Eigenschaften der Keramik infolge von Reduktionsreaktionen negativ beeinflussen.

In der Druckschrift DE 20023051 U1 ist ein Verfahren zur Herstellung piezoelektrischer Bauelemente angegeben, die anstelle der teuren Ag/Pd Innenelektroden kupferhaltige Elektroden aufweisen, wobei die piezoelektrischen Kenndaten auf Keramikmassen der bevorzugten Zusammensetzung Pb_{0,97}Nd_{0,02}□_{0,01}(Zr_{0,54}Ti_{0,46})O₃ beruhen. Das Zeichen "□" steht für eine Leerstelle im Kristallgitter. Keramikmassen einer derartigen Zusammensetzung sind insbesondere für Ag/Pd-Innenelektroden und Sinterung an Luft bei 1120°C geeignet und bezüglich ihrer piezoelektrischen Eigenschaften darauf eingestellt, daß sie partiell Silber aus den Innenelektroden aufnehmen. Die Aufnahme des Silbers wird dabei durch die Gegenwart von Luftsauerstoff beim Sintern ermöglicht. Gleichzeitig wird das Kornwachstum gefördert, so daß sich im fertigen Bauelement eine Keramikzusammensetzung Pb_{0,96}Nd_{0,02}Ag_{0,02}(Zr_{0,54}Ti_{0,46})O₃ mit einem für die Anwendung günstigen Korngefüge ergibt.

Demgegenüber weisen die piezoelektrischen Vielschicht-Bauelemente mit der gleichen Ausgangszusammensetzung der Keramik und kupferhaltigen Innenelektroden einen derartigen Silbergehalt nicht auf, was zur Folge hat, daß die für optimale piezoelektrische Eigenschaften vorteilhafte morphotrope Phasengrenze in der Keramik nicht mehr vorliegt und die mittlere Korngröße geringer ausfällt. Letzteres ist vor allem auch ein Resultat der niedrigeren Sintertemperatur von ca. 1000°C, die bei der Anwendung von kupferhaltigen Innenelektroden einzuhalten ist, um ein Aufschmelzen der Elektroden zu vermeiden.

Während das Silber bei der Sinterung von Vielschicht-Bauelementen auf der Basis der PZT-Keramik der Zusammensetzung Pb_{0,97}Nd_{0,02}□_{0,01}(Zr_{0,54}Ti_{0,46})O₃ mit Ag/Pd-Innenelektroden an Luft bei 1120°C im Querschnitt über die gesamte gesinterte Keramikschicht gleichmäßig eingebaut wird, so daß sich in der Piezokeramik die Zusammensetzung Pb_{0,96}Nd_{0,02}Ag_{0,02}(Zr_{0,54}Ti_{0,46})O₃ einstellt, beträgt der Kupfergehalt in Keramikschichten der o. g. Zusammensetzung bei der Sinterung eines keramischen Vielschicht-Bauelements mit kupferhaltigen Innenelektroden nur ca. 0,1 m %.

Die Abweichung von der morphotropen Phasengrenze wird z. B. an einer kleineren Dielektrizitätskonstante ε sowie einer Zunahme des Temperaturkoeffizienten TKε der DK (gemessen z. B. zwischen -20°C und 60°C aufsteigend) und ebenso an einem geringer ausfallenden Betrag der Auslenkung S₃ bei gleicher Feldstärke E₃ erkannt (DK = Dielektrizitätskonstante).

Der Auslenkungsparameter d₃₃ ( = piezoelektrische Ladungskonstante) ist durch die Beziehung S₃ = d₃₃ · E₃ definiert. Darüber hinaus ist für die Beurteilung der Eignung einer Piezokeramik in Vielschichtbauelementen der dielektrische Verlust L maßgebend, der je nach der elektrischen Ansteuerung eine mehr oder weniger starke Erwärmung im Bauelement hervorruft und durch den Wirkungsgrad η = Eₐ/Eₑ (Eₐ = auskoppelbare Energie, Eₑ= eingekoppelte Energie) in Verbindung mit der für eine bestimmte Auslenkung verbundenen elektrischen Feldstärke E = U/d (d = Dicke der Keramikschicht) gemäß der Beziehung L = (1/2)U²C (1-η) beschrieben werden kann (C = Kapazität).

Es ist die Aufgabe der Erfindung, ein insbesondere für keramische Vielschicht-Bauelemente geeignetes Keramikmaterial oben genannter Art anzugeben, das einen verringerten dielektrischen Verlust L und daher im Dauerbetrieb eine geringe Erwärmung der Vielschicht-Bauelemente bei zugleich einer hinreichenden Auslenkung S₃ gewährleistet.

Dokument WO 01/45138 offenbart ein piezoelektrisches Keramikmaterial mit der Zusammensetzung Pb_{1-x-y}SEₓV_{x/2}Cu_{y}(Zr_{0,54-z}Ti_{0,46+z})O₃ mit 0,01 < x < 0,05 und 0 < y < 0,06, wobei SE ein Seltenerdmetall und V eine Vakanz ist.

Die Aufgabe der Erfindung wird durch ein piezoelektrisches Keramikmaterial eingangs genannter Art mit dem Kennzeichen des Anspruchs 1 gelöst.

Das erfindungsgemäße Keramikmaterial zeichnet sich durch eine Zusammensetzung aus, die zumindest einen Anteil von Bleizirkonattitanat der allgemeinen Formel Pb_{1-3x/2-y/2}SEₓ□_{x/2-y/2}Cu^{I}_{y}(Zr_{0,5515-z}Ti_{0,4485+z})O₃ mit 0,01 < x < 0,04 und 0 < y < x/2 aufweist. Der Parameter z kann einen beliebigen Wert zwischen -0,15 < z < +0,15 annehmen, vorzugsweise -0,016 < z < 0,0205. SE steht für ein Seltenerdmetall, ausgewählt aus La, Nd, Sm, Gd, Tb, Dy, Ho, Er, Tu, Yb, Lu und Y. Der Parameter x ist durch die Wertigkeit des Seltenerdmetalls bestimmt. Das durch den Parameter z gegebene Verhältnis Zr/Ti ist in Abhängigkeit vom Kupfergehalt, d. h. vom Parameter y, so gewählt, daß das Keramikmaterial bezüglich seines Phasenzustands (im Phasenzustandsdiagramm) auf die morphotrope Phasengrenze eingestellt ist.

Die Phasengrenze im Sinne der Erfindung ist nicht zwangsläufig scharf definiert, sondern kann im Phasenzustandsdiagramm einem morphotropen Phasenbereich z. B. zwischen zwei definierten Kristallmodifikationen entsprechen.

Erfindungsgemäß wird der Einbau des zweiwertigen Cu²⁺ Kations auf den B-Plätzen des Keramikgitters aus unten dargelegten Gründen verhindert. Das Kupfer bleibt auch nach der Sinterung der Keramikmasse einwertig.

Als Folge des Einbaus von Cu⁺-Kationen auf A-Plätzen des Keramikgitters wird im Hinblick auf die physikalischen Eigenschaften insbesondere die Verminderung der dielektrischen Verluste L im Keramikmaterial erreicht, vgl. Tabelle 5.

Eine vorteilhafte Veränderung der Massezusammensetzung der Piezokeramik ergibt sich zum Beispiel, indem das Molverhältnis Zr/Ti durch Variation des Parameters z entsprechend der Formel Pb_{1-2x/2}SEₓ□_{x/2}(Zr_{0,5515-z}Ti_{0,4485+z})O₃ soweit verändert wird, daß die morphotrope Phasengrenze auch in der Keramik erreicht wird, die infolge einer Sinterung bei ca. 1000°C in Gegenwart von Cu-Innenelektroden unter Inertbedingungen, das heißt ohne den Einbau von Silber, entsteht. Dadurch können besonders günstige piezoelektrische Eigenschaften der Keramik erhalten werden.

Es ist in einer anderen Variante von Vorteil, die Anpassung der Zusammensetzung des Keramikmaterials an die kupferhaltigen Innenelektroden dadurch zu erreichen, daß man der keramischen Masse - zur Variation des Parameters y entsprechend der allgemeinen Formel Pb_{1-3x/2-y/2}SEₓ□_{x/2-y/2}CU_{y}(Zr_{0,5515-z}Ti_{0,4485+z})O₃ mit 0,01 < x < 0,04 und 0 < y < x/2 einen bestimmten Anteil von Kupferoxid hinzufügt.

Wird der Ausgangsstoffmischung bei einem PZT-Masseansatz bestimmter Zusammensetzung etwas CuO zugesetzt, ist davon auszugehen, daß bei der anschließenden Kalzination an der Luft ein Einbau von Cu²⁺-Ionen in das Perowskitgitter der Keramik zustande kommt, wobei Cu²⁺ als Akzeptor die Besetzung von B-Plätzen bevorzugt, so daß sich im Ergebnis der Kalzination unter der Annahme eines vollständigen Umsatzes zunächst die Formel Pb_{1-3x/2}SEₓ□_{x/2}[(Zr_{0,5515-z}Ti_{0,4485+z})]_{1-y}CU^{II}_{y}O_{3-y}□_{y} ergibt. Cu²⁺ ist jedoch unter den Bedingungen einer Gemeinsamsinterung mit kupferhaltigen Innenelektroden nicht beständig. Es bilden sich Cu⁺-Ionen, die aufgrund ihres großen Ionenradius in der Perowskitstruktur die Besetzung von A-Plätzen bevorzugen.

Dementsprechend wird die gesinterte Keramik eine Zusammensetzung gemäß der Formel Pb_{1-3x/2-y/2}SEₓ□_{x/2-y/2}CU_{y}(Zr_{0,5515-z}Ti_{0,4485+z})O₃ mit Cu⁺-Ionen auf A-Plätzen, zum Beispiel im Fall y = x mit Pb_{1-3x/2}SEₓCU^{I}ₓ(Zr_{0,5515-z}Ti_{0,4485+z})O₃ zugeordnet. Die Sauerstoffleerstellen, die beim Einbau von Cu²⁺ auf B-Plätzen ausgebildet werden, sind durch den Umbau des Gitters während der Sinterung infolge Cu⁺-Bildung nicht mehr vorhanden. Beim Erreichen des (für das jeweilige SE-Kation) maximalen Cu-Gehalts wird das in Form eines Kupferoxids zugesetzte Cu durch das Perowskitgitter nicht mehr aufgenommen.

Um den Einbau von Cu²⁺-Ionen auf B-Plätzen zu umgehen, wird der Masseansatz einer betreffenden Zusammensetzung vorteilhaft zunächst ohne den Zusatz von CuO umgesetzt, das Kupferoxid aber anschließend als Cu₂O dem Schlicker hinzugefügt, so daß der Einbau auf den A-Plätzen des Perowskitgitters nach erfolgter Entbinderung des piezoelektrischen Vielschicht-Bauelements während des Sinterns unmittelbar erfolgen kann.

Die Erfindung wird an folgendem Ausführungsbeispiel näher erläutert.

Eine aus
1) TiO₂, ZrO₂ bzw. einem durch Mischfällung hergestellten Precursor (Zr,Ti)O₂
2) PbCO₃ bzw. Ph3O₄,
3) Dotierstoffen aus einem Oxid eines Seltenerdmetalls, z. B. Nd₂O₃ , und
4) einem Zusatz von CuO
bestehende Rohstoffmischung wird mit a) einer Zusammensetzung, die der morphotropen Phasengrenze entspricht oder dieser nahe kommt und b) einem PbO-Überschuß von maximal 5 % zur Förderung der Sinterverdichtung eingewogen. Diese Mischung wird zur Gleichverteilung der Komponenten in einer wässrigen Suspension einer Mahlstufe unterzogen und nach dem Filtrieren und Trocknen z. B. bei 900 bis 950°C an der Luft kalziniert.

In einer weiteren vorteilhaften Variante wird der Zusatz von Kupferoxid auf der Stufe der Kalzination nicht angewendet. Es bildet sich bei der Kalzination eine piezokeramische Perowskit-Mischkristallphase.

Um bereits bei 1000°C, d. h. unterhalb der Schmelztemperatur von Kupfer innerhalb von 2 bis 8 Stunden eine Sinterverdichtung der Keramikmasse zu erreichen, wird eine Feinmahlung des Keramikpulvers bis auf eine mittlere Korngröße < 0,4 µm durchgeführt. Die Sinteraktivität des Pulvers erweist sich dann als ausreichend, um eine Keramikdichte von mehr als 97% der theoretischen Dichte bei zugleich hinreichendem Kornwachstum und ausreichender mechanischer Festigkeit im Gefüge zu ergeben.

Das fein gemahlene Keramikpulver wird unter Verwendung eines Dispergators zu einem wässrigen Schlicker mit ca. 70 m-% (= Masseprozent) Feststoffgehalt, das entspricht etwa 24 Vol-%, suspendiert. Dabei wird der für eine optimale Dispergierung gerade notwendige Dispergatoranteil, zum Beispiel Ammoniumcitrat, in einer Versuchsreihe gesondert ermittelt, was am Erreichen eines Viskositätsminimums erkannt werden kann. Im Fall der Herstellung einer Kupferoxid enthaltenden Keramik aus einem Umsatzpulver, dem vor der Kalzination noch kein Kupferoxid hinzugefügt worden war, mischt man einen bestimmten Anteil des Kupfer(I)-Oxids Cu₂O zu. Man setzt für die Ausbildung der Piezokeramik-Grünfolien zu den dispergierten Feststoffpulversuspensionen ca. 6 m-% eines handelsüblichen thermohydrolytisch abbaubaren Binders hinzu. Dafür erweist sich eine wässrige Polyurethandispersion als vorteilhaft. Man mischt zum Beispiel in einer Dispermat-Mühle und erhält auf diesem Weg einen für den Folienziehprozeß geeigneten Schlicker.

Die Entbinderung erfolgt thermohydrolytisch mittels Wasserdampf in einer Stickstoffatmosphäre. Die hydrolytische Spaltung des Binders gelingt zum Hauptteil bei einer relativ niedrigen Temperatur von 220 ± 50°C bei einem Wasserdampfpartialdruck > 200 mbar. Der Sauerstoffpartialdruck wird auf einen Wert eingestellt, der mit den Cu-haltigen Elektroden verträglich ist, d. h. bei dem das metallische Kupfer nicht oxidiert und bei dem die Keramik nicht reduziert wird. Die Einstellung des Sauerstoffpartialdrucks erfolgt durch Gettern des Sauerstoffs aus der wasserdampfhaltigen Stickstoffatmosphäre an großen Oberflächen von Cu oder durch Zudosierung von Wasserstoff.

Zur Ermittlung der optimalen Keramik-Zusammensetzung, z. B. des der morphotropen Phasengrenze entsprechenden Verhältnisses Ti/Zr bzw. des günstigsten Gehalts an Kupfer, wird zunächst eine Reihe kompakter scheibchenförmiger Keramikkörper hergestellt, die durch Übereinanderstapeln und Laminieren mehrerer 40 bis 50 µm dicker Grünfolien erhalten werden. Nach dem Sintern werden die fertigen Keramikproben beidseitig kontaktiert und deren elektrische Eigenschaften gemessen.

Die elektrischen Eigenschaften der kompakten Keramikproben in den Reihen variabler Zusammensetzung sind in den Tabellen 2 bis 4 angegeben. Die elektrischen Eigenschaften von Aktoren mit kupferhaltigen Innenelektroden bei optimierter Keramikzusammensetzung sind in der Tabelle 5 angegeben.

Beispiele für die Entbinderungsführung für die kompakten Keramikproben sind unter Angabe des verbleibenden Restkohlenstoffgehaltes der erhaltenen Bauteile in Tabelle 1 zu finden. Der Taupunkt für Wasserdampf des Entbinderungsprogrammes liegt bei 97°C.

**Tabelle 1: Entbinderung von kompakten Keramikproben (MLP) und den entsprechenden keramischen Vielschicht-Bauelementen (Aktoren)**

| Bedingungen: R Rampe, H Haltezeit | Proben | Erreichter Restkohlenstoffgehalt C |
|---|---|---|
| R: 6,5 K/h ⇒ 100°C, | Keramikproben | 220 ppm |
| R: 6,2 K/h ⇒ 220°C, | MLP | |
| R: 5 K/h ⇒ 350°C, | | |
| R: 15K/h ⇒ 580°C, H: 15h | | |
| R: 150K/h, Ende: 25°C | | |
| | Aktoren mit 338 Cu-Elektroden | 184 ppm |

Nach dem beschriebenen Entkohlungsregime und angegebenen Restkohlenstoffgehalt gelingt bei der anschließenden Sinterung bei ca. 1000°C eine Verdichtung der Keramik von > 97% der theoretischen Dichte ohne schädliche reduktive Degradation.

Die Keramikproben MLP wurden für die Messung der dielektrischen Eigenschaften beidseitig durch Bedampfen mit einer Goldelektrode versehen.

In Tabelle 2 sind die Eigenschaften von kompakten, aus Folien gefertigten Keramikproben Pb_{1-3x/2-y/2}SEₓ□_{x/2-y/2}CU_{y}(Zr_{0,5515-z}Ti_{0,4485+z})O₃ mit Nd₂O₃ als Dotand und x = 0,02 ohne Kupferoxidzusatz (y = 0) zusammengestellt, wobei das Zr/Ti-Verhältnis der Proben variiert wurde. Die Herstellung erfolgte in N₂-Atmosphäre bei einem durch den Wasserdampfpartialdruck P_{H2O} und den Wasserstoffpartialdruck P_{H2} eingestellten Restsauerstoffpartialdruck p_{O2} = 10⁻² - 10⁻³ Pa. Gemessen wurde nach einer Polung mit E = 2 kV/mm bei Raumtemperatur.

**Tabelle 2. Eigenschaften kompakter quadratischer Keramikproben MLP (Kantenlänge a = 11,5 mm, Dicke h = 1 mm) in der Reihe Pb_{0,97}Nd_{0,02}□_{0,01}(Zr_{0,5515-z}Ti_{0,4485+z})O₃ zwecks Ermittlung der morphotropen Phasengrenze mit Angabe des mittleren statistischen Fehlers aus 5 bis 10 Einzelproben.**

| z | Dielektrizitätskonstante ε | Temperaturkoeffizient TKε | Piezoelektr. Ladungskonstante d₃₃ [pm V⁻¹] | Dichte ρ [g cm⁻³] |
|---|---|---|---|---|
| 0 | 1339 ± 9 | 6037 ± 225 | 720 ± 5 | 7,76 ± 0, 04 |
| 0,0025 | 1360 ± 23 | 4985 ± 91 | 728 ± 12 | 7, 54 ± 0,10 |
| 0,005 | 1330 ± 15 | 5094 ± 150 | 723 ± 8 | 7,59 ± 0,02 |
| 0,009 | 1527 ± 28 | 3913 ± 247 | 753 ± 14 | 7,89 ± 0,02 |
| 0,0125 | 1436 ± 74 | 3083 ± 265 | 714 ± 40 | 7,90 ± 0,02 |
| 0,0205 | 1598 ± 21 | 2740 ± 110 | 707 ± 20 | 7,88 ± 0,02 |

Man erkennt, daß die Kleinsignal-Dielektrizitätskonstante ε bei der vorgenommenen Variation der z-Werte ansteigt und der Temperaturkoeffizient TKε abfällt, während der d₃₃-Wert bei z=0,009 einen Maximalwert durchläuft. Demnach entspricht die Formel Pb_{0,97}Nd_{0,02}□_{0,01}(Zr_{0,5425}Ti_{0,5475})O₃ einer Keramikmasse, die bei einer Zubereitung ohne CuO-Zusatz an die morphotrope Phasengrenze angepaßt ist.

In Tabelle 3 sind die Eigenschaften von kompakten, aus Folien gefertigten Keramikproben der Zusammensetzung Pb_{1-3x/2-y/2}SEₓ□_{x/2-y/2}CU_{y}(Zr_{0,5515-z}Ti_{0,4485+z})O₃ mit Nd₂O₃ als Dotand und x = 0,02 sowie z = 0 zusammengestellt, wobei der Kupfergehalt mit dem Parameter y variiert wurde, der in einer Fall (bei y = 0,04) die durch x = y definierte obere Grenze der homogenen Löslichkeit im Perowskitgitter überschreitet. Die Herstellung erfolgte unter N₂ bei einem durch p_{H2O} und p_{H2} eingestellten Restsauerstoffpartialdruck p_{O2} = 10⁻² - 10⁻³ Pa. Gemessen wurde nach einer Polung mit E = 2 kV/mm bei der Raumtemperatur.

**Tabelle 3 Eigenschaften kompakter quadratischer Keramikproben MLP (Kantenlänge a = 11,5 mm, Dicke h = 1 mm) in der Reihe Pb_{0,97-y/2}Nd_{0,02}Cu_{y}(Zr_{0,551}Ti_{0,4485})O₃ zwecks Ermittlung eines optimalen Kupfergehalts mit Angabe des mittleren statistischen Fehlers aus 5 bis 10 Einzelproben.**

| y | Dielektrizitätskonstante ε | Temperaturkoeffizient TKε | Piezoelektr. Ladungskonstante d₃₃ [pm V⁻¹] | Dichte ρ [g cm⁻³] |
|---|---|---|---|---|
| 0 | 1339 ± 9 | 6037 ± 225 | 720 ± 5 | 7,76 ± 0,04 |
| 0,005 | 1125 ± 6 | 4202 ± 19 | 645 ± 6 | 7,78 ± 0,03 |
| 0,010 | 1100 ± 21 | 3466 ± 136 | 540 ± 11 | 7,58 ± 0,11 |
| 0,020 | 1317 ± 11 | 4107 ± 105 | 739 ± 4 | 7,71 ± 0,03 |
| 0,040 | 1151 ± 16 | 4112 ± 406 | 641 ± 11 | 7,93 ± 0,11 |

Aus den Werten der Tabelle geht hervor, daß die Keramikzusammensetzung mit y = 0,02 einem optimalen Kupfergehalt entspricht.

Folgerichtig wurde in Tabelle 4 nochmals das Verhältnis Zr/Ti variiert, um auch für einen Cu-Gehalt y = 0,02 die morphotrope Phasengrenze festzustellen.

**Tabelle 4 Eigenschaften kompakter quadratischer Keramikproben MLP (Kantenlänge a = 11,5 mm, Dicke h = 1 mm) in der Reihe Pb_{0,96}Nd_{0,02}CU_{0,02}(Zr_{0,5515-z}Ti_{0,4485+z})O₃ zwecks Ermittlung der morphotropen Phasengrenze mit Angabe des mittleren statistischen Fehlers aus 5 bis 10 Einzelproben.**

| z | Dielektrizitätskonstante ε | Temperaturkoeffizient TKε | Piezoelektr. Ladungskonstante d₃₃ [pm V⁻¹] | Dichte ρ [g cm⁻³] |
|---|---|---|---|---|
| -0,016 | 1005 ± 13 | 4970 ± 52 | 500 ± 6 | 7,40 ± 0,03 |
| -0,008 | 1037 ± 15 | 4484 ± 207 | 454 ± 9 | 7,40 ± 0,03 |
| 0 | 1317 ± 1 | 4107 ± 105 | 739 ± 4 | 7,71 ± 0,03 |
| 0,009 | 1208 ± 32 | 3717 ± 58 | 581 ± 26 | 7,88 ± 0,02 |
| 0,0125 | 1214 ± 37 | 3707 ± 67 | 566 ± 11 | 7,89 ± 0,03 |
| 0,0205 | 1226 ± 39 | 3380 ± 115 | 513 ± 18 | 7,90 ± 0,02 |

Man findet, daß bei dem offensichtlich durch den Gehalt an SE-Kationen, in diesem Fall Nd³⁺, gesteuerten optimalen Cu-Gehalt y = 0,02 der Bestwert für die piezoelektrische Ladungskonstante d₃₃ wieder bei einem Wert z = 0 liegt, das heißt die morphotrope Phasengrenze stellt sich beim Einbau von Cu⁺-Ionen anstelle von Ag⁺-Ionen etwa bei dem gleichen Gehalt von Ti und Zr, d. h. beim Zr/Ti-Verhältnis von ca. 1 ein.

Piezoelektrische Vielschicht-Bauelemente (Aktoren), z. B. Piezostacks mit mehreren hundert kupferhaltigen Innenelektroden, auf der Basis der erfindungsgemäßen Keramikmassen werden standardmäßig durch Bedrucken der Keramikschichten mit einer Kupferpaste, Verstapeln der bedruckten Keramikschichten, Laminieren, Entbindern und Sintern erhalten.

In Tabelle 5 sind die Eigenschaften von drei Aktoren unterschiedlicher Keramikzusammensetzung
1) Pb_{0,97}Nd_{0,02}□_{0,01}(Zr_{0,5515}Ti_{0,4485})O₃ ohne Anpassung an Cu - Innenelektroden;
2) Pb_{0,97}Nd_{0,02}□_{0,01}(Zr_{0,5425}Ti_{0,4575})O₃ mit Anpassung des Zr/Ti-Verhältnisses an Cu-Innenelektroden;
3) Pb_{0,96}Nd_{0,02}Cu_{0,02}(Zr_{0,5515}Ti_{0,4485}) mit an die Dotierung angepaßtem Cu-Gehalt und eingestellter morphotroper Phasengrenze
mit jeweils 360 Innenelektroden und einer Keramikschichtdicke von 80 µm zusammengestellt, wie sie nach einer Polung mit E = 2 kV/mm (a) bei Raumtemperatur und (b) bei 180 °C gemessen werden. Neben den Kleinsignal-Eigenschaften ε und TK_{ε} ist hier auch die Großsignal-Dielektrizitätskonstante angegeben, die sich aus der Polarisation durch eine Spannung berechnen

läßt, welche z. B. bei den Aktoren zu einer Auslenkung von 40 µm führt.

**Tabelle 5: Eigenschaften von Aktoren mit kupferhaltigen Innenelektroden auf der Basis der Keramik**

| | | | | | | |
|---|---|---|---|---|---|---|
| 1) Pb_{0,97}Nd_{0,02}□_{0,01}(Zr_{0,5515}Ti_{0,4485})O₃ ohne Kupferoxidzusatz und ohne Anpassung an die morphotrope Phasengrenze, | | | | | | |
| 2) Pb_{0,97}Nd_{0,02}□_{0,01}(Zr_{0,5425}Ti_{0,4575})O₃ mit Anpassung des Zr/Ti-Verhältnisses an die morphotrope Phasengrenze, sowie | | | | | | |
| 3) einer durch Kupferoxidzusatz modifizierten Keramik Pb_{0,96} Nd_{0,02}Cu_{0,02}(Zr_{0,5515} Ti_{0,4485}), deren Zr/Ti-Verhältnis an die morphotrope Phasengrenze angepaßt ist. Gemessen wurde nach einer Polung mit 2 kV/mm | | | | | | |
| (a) bei Raumtemperatur und (b) bei 180°C. | | | | | | |

| z | Dielektrizitätskonstante ε Klein- Großsignal signal | | Temperaturkoeffizient TK ε (Klein-signal) | Piezoel. Ladungskonstante d₃₃ [pm V⁻¹] | Wirkungs grad η | Dielektrische Verlustenergie L [mJ] |
|---|---|---|---|---|---|---|
| (1) (a) | 1214±30 | 3110±87 | 3936±82 | 592 ± 18 | 50,4±0,4 | 50 ± 2 |
| (b) | | 2772±50 | | 632 ± 11 | 56,5±0,4 | 34 ± 1 |
| (2) (a) | 1358±27 | 2984±118 | 2949±41 | 568 ± 15 | 51±0,7 | 51 ± 2 |
| (b) | | 2841±57 | | 614 ± 11 | 57± 1 | 37 ± 2 |
| (3) (a) | 1216±8 | 2747±102 | 2860±42 | 569 ± 11 | 55± 1 | 44 ± 1 |

Die Werte der Tabelle 5 lassen im Vergleich der Aktoren mit den beiden Keramiken (1) und (2) eine Eigenschaftsverbesserung hinsichtlich einer Verringerung des TKε bei der Keramik 2a gegenüber der Keramik 1a erkennen. Eine signifikante Verminderung der dielektrischen Verlustenergie L kommt aber erst durch den Kupfereinbau zustande. Mit 44 mJ liegt der Wert für den dielektrischen Verlust L bei der Keramik (3) mit Polung bei Raumtemperatur deutlich unter den Werten jener Aktoren, die mit der Keramik ohne Kupferoxidzusatz hergestellt wurden. Eine weitere Verbesserung kann durch die Warmpolung bei zum Beispiel 180°C erreicht werden. Außerdem ist auch hier die Abhängigkeit der Kleinsignalkapazität von der Temperatur geringer.

## Patentansprüche

1. Piezoelektrisches Keramikmaterial
der allgemeinen Zusammensetzung ABO₃,
das im wesentlichen Bleizirkonattitanat enthält und Perowskitgitter aufweist,
wobei A für A-Plätze und B für B-Plätze des Kristallgitters steht,
**gekennzeichnet durch**
eine Zusammensetzung, die zumindest einen Anteil von Bleizirkonattitanat der allgemeinen Formel
Pb_{1-3x/2-y/2}SEₓ□_{x/2-y/2}Cu^{I}_{y}(Zr_{0,5515-z}Ti_{0,4485+z})O₃ mit 0,01 < x < 0,04 und 0 < y < x/2 aufweist,
wobei SE ein Seltenerdmetall ist, ausgewählt aus La, Nd, Sm, Gd, Tb, Dy, Ho, Er, Tu, Yb, Lu und Y, wobei das Zeichen "□" für eine Leerstelle im Kristallgitter steht,
wobei der Parameter x **durch** die Wertigkeit des Seltenerdmetalls bestimmt ist,
wobei der Parameter z in Abhängigkeit vom Parameter y so gewählt ist, daß das Keramikmaterial auf die morphotrope Phasengrenze eingestellt ist.

2. Keramikmaterial nach Anspruch 1,
bei dem Cu in das Perowskitgitter des Keramikmaterials zumindest teilweise auf A-Plätzen eingebaut ist, wobei das auf A-Plätzen eingebaute Cu als einwertig positives Kation Cu⁺ vorliegt.

3. Verfahren zur Herstellung eines Keramikmaterials nach einem der Ansprüche 1 bis 2,
bei dem eine Kupferoxid CuO enthaltene Keramik-Rohstoffmischung bereitgestellt wird,
bei dem die Keramik-Rohstoffmischung unter inerten Bedingungen kalziniert wird, wobei die Kalzination in einer reduzierten Atmosphäre unter einem Sauerstoffpartialdruck durchgeführt wird, bei dem Cu und Kupferoxid im Gleichgewicht sind und koexistieren,
bei dem das kalzinierte Keramikprodukt fein gemahlen, homogenisiert und anschließend gesintert wird.

4. Verfahren nach Anspruch 3,
bei dem die Kalzination in einer feuchten Stickstoffatmosphäre durchgeführt wird.

5. Verfahren zur Herstellung eines Keramikmaterials nach einem der Ansprüche 1 bis 2,
bei dem eine Keramik-Rohstoffmischung ohne einen KupferoxidZusatz kalziniert wird, wobei bei der Kalzination eine piezokeramische Perowskit-Mischkristallphase gebildet wird, bei dem in einen Schlicker Kupferoxid Cu₂O hinzugefügt wird, wobei das Kupferoxid im Schlicker gleichmäßig verteilt wird, bei dem das Produkt der Kalzination fein gemahlen und mit dem Schlicker vermischt wird, wodurch eine Keramikmasse gebildet wird,
bei dem die Keramikmasse unter inerten Bedingungen gesintert wird.

6. Verfahren nach einem der Ansprüche 3 bis 5,
bei dem die Sinterung in einer feuchten Stickstoffatmosphäre durchgeführt wird.

7. Piezoelektrisches Vielschichtbauelement
mit Keramikschichten aus einem Keramikmaterial nach einem der Ansprüche 1 bis 2 und innen liegenden Elektrodenschichten, wobei die Keramikschichten und die Elektrodenschichten in abwechselnder Reihenfolge übereinander angeordnet sind, wobei die innen liegenden Elektroden zumindest einen Anteil des metallischen Kupfers enthalten.

## Claims

1. Piezoelectric ceramic material
of the general composition ABO₃,
substantially containing lead zirconate titanate and having perovskite lattices,
wherein A represents A-sites and B represents B-sites in the crystal lattice,
**characterized by**
a composition having at least a proportion of lead zirconate titanate of the general formula Pb_{1-3x/2-y/2}REₓ□_{x/2-y/2}Cu^{I}_{y}(Zr_{0,5515-z}Ti_{0,4485+z})O₃ where 0.01 < x < 0.04 and 0 < y < x/2,
wherein RE is a rare earth metal selected from La, Nd, Sm, Gd, Tb, Dy, Ho, Er, Tu, Yb, Lu and Y, wherein □ represents a vacancy in the crystal lattice,
wherein the parameter x is determined by the valence of the rare earth metal,
and wherein the parameter z is selected as a function of the parameter y such that the ceramic material is set to the morphotropic phase boundary.

2. Ceramic material according to Claim 1,
in which Cu is incorporated at least partially at A-sites in the perovskite lattice of the ceramic material, the Cu incorporated at A-sites being present in the form of monovalent positive cation Cu⁺.

3. Process for the production of a ceramic material according to either of Claims 1 and 2,
in which a ceramic raw material mixture containing copper oxide CuO is provided,
in which the ceramic raw material mixture is calcined under inert conditions, the calcination being carried out in a reducing atmosphere under an oxygen partial pressure, in which Cu and copper oxide are in equilibrium and coexist,
and in which the calcined ceramic product is finely ground, homogenized and subsequently sintered.

4. Process according to Claim 3,
in which the calcination is carried out in a moist nitrogen atmosphere.

5. Process for the production of a ceramic material according to either of Claims 1 and 2,
in which a ceramic raw material mixture is calcined without the addition of copper oxide, a piezoceramic perovskite solid solution phase being formed during the calcination,
in which copper oxide Cu₂O is added to a slip,
the copper oxide being uniformly distributed in the slip,
in which the product of the calcination is finely ground and mixed with the slip, as a result of which a ceramic mass is formed,
and in which the ceramic mass is sintered under inert conditions.

6. Process according to one of Claims 3 to 5,
in which the sintering is carried out in a moist nitrogen atmosphere.

7. Piezoelectric multi-layered component
with ceramic layers composed of a ceramic material according to either of Claims 1 and 2 and electrode layers lying on the inside,
wherein the ceramic layers and the electrode layers are arranged above one another in an alternating sequence, and wherein the electrodes lying on the inside contain at least a proportion of metallic copper.

## Revendications

1. Matériau céramique piézoélectrique
de composition générale ABO₃
qui contient pour l'essentiel du zirconate titanate de plomb et qui comporte un réseau perowskite,
A représentant des emplacements A et B des emplacements B du réseau cristallin,
**caractérisé par**
une composition qui a au moins une proportion de zirconate titanate de plomb de formule générale Pb_{1-3x/2-y/2}SEₓ□_{x/2-y/2}Cu^{I}_{y}(Zr_{0,5515-z} Ti_{0,4485+z})O₃
avec 0,01 < x < 0,04 et 0 < y< x/2
SE étant un métal de terre rare choisi parmi La, Nd, Sm, Gd, Tb, Dy, Ho, Er, Tu, Yb, Lu et Y, le signe « □ » représentant une lacune dans le réseau cristallin,
le paramètre x étant déterminé par la valence du métal de terre rare,
le paramètre z étant choisi en fonction du paramètre y de manière à ce que le matériau céramique soit réglé à la limite de phase morphotrope.

2. Matériau céramique suivant la revendication 1,
dans lequel Cu dans le réseau perowskite du matériau céramique est inséré au moins en partie sur des emplacements A, le Cu inséré sur des emplacements A étant présent sous la forme d'un cation Cu⁺ monovalent.

3. Procédé de production d'un matériau céramique suivant l'une des revendications 1 à 2,
dans lequel on prépare un mélange de matière première céramique contenant de l'oxyde de cuivre CuO
dans lequel on calcine le mélange de matière première céramique dans des conditions inertes, la calcination s'effectuant dans une atmosphère réduite sous une pression partielle d'oxygène à laquelle Cu et l'oxyde de cuivre sont en équilibre et coexistent,
dans lequel on broie finement le produit céramique calciné, on l'homogénéise et ensuite on le fritte.

4. Procédé suivant la revendication 3,
dans lequel on effectue la calcination dans une atmosphère d'azote humide.

5. Procédé de production d'un matériau céramique suivant l'une des revendications 1 à 2,
dans lequel on calcine un mélange de matière première céramique sans une addition d'oxyde de cuivre une phase de cristal mixte de perowskite piézocéramique se formant à la calcination,
dans lequel on ajoute de l'oxyde de cuivre Cu₂O à une suspension, l'oxyde de cuivre étant réparti uniformément dans la suspension,
dans lequel on broie finement le produit de la calcination et on le mélange à la suspension en formant ainsi une composition céramique,
dans lequel on fritte la composition céramique dans des conditions inertes.

6. Procédé suivant l'une des revendications 3 à 5,
dans lequel on effectue le frittage dans une atmosphère d'azote humide.

7. Composant stratifié piézoélectrique
comprenant des couches de céramique en un matériau céramique suivant l'une des revendications 1 à 2 et des couches d'électrode se trouvant à l'intérieur, les couches céramiques et les couches d'électrode étant disposées les unes sur les autres en alternance, les électrodes se trouvant à l'intérieur contenant au moins une certaine proportion du cuivre métallique.
